Europäisches Patentamt

(19)　European Patent Office

Office européen des brevets

(11)　**EP 1 392 894 B1**

(12)　**FASCICULE DE BREVET EUROPEEN**

| | |
|---|---|
| (45) Date de publication et mention de la délivrance du brevet:<br>**24.11.2004　Bulletin 2004/48** | (51) Int Cl.⁷: **C30B 23/02** |
| (21) Numéro de dépôt: **02751239.1** | (86) Numéro de dépôt international:<br>**PCT/FR2002/001806** |
| (22) Date de dépôt: **29.05.2002** | (87) Numéro de publication internationale:<br>**WO 2002/097172 (05.12.2002 Gazette 2002/49)** |

(54)　**EQUIPEMENTS D'EPITAXIE PAR JET MOLECULAIRE**

VORRICHTUNGEN FÜR MOLEKULARSTRAHLEPITAXIE

MOLECULAR BEAM EPITAXY EQUIPMENT

(84) Etats contractants désignés:
**AT BE CH CY DE DK ES FI FR GB GR IE IT LI LU MC NL PT SE TR**

(30) Priorité: **29.05.2001　FR 0106997**

(43) Date de publication de la demande:
**03.03.2004　Bulletin 2004/10**

(73) Titulaire: **Addon**
**78420 Carrières-sur-Seine (FR)**

(72) Inventeurs:
• **BOUCHAiB, Pierre**
**F-78411 Mantes la Ville (FR)**

• **STEMMELEN, Franck**
**F-95280 Jouy-le-Moutier (FR)**

(74) Mandataire: **Breese, Pierre**
**3, avenue de l'Opéra**
**75001 Paris (FR)**

(56) Documents cités:
**EP-A- 0 692 556**　　　**WO-A-97/06292**
**WO-A-98/56965**　　　**US-A- 4 424 104**
**US-A- 5 714 008**

• **PATENT ABSTRACTS OF JAPAN vol. 1997, no. 09, 30 septembre 1997 (1997-09-30) & JP 09 118590 A (HITACHI CABLE LTD), 6 mai 1997 (1997-05-06)**

**Description**

La présente invention concerne le domaine des équipements d'épitaxie par jet moléculaire.

L'épitaxie par jet moléculaire consiste à envoyer des atomes ou des molécules à la surface d'un substrat dans un vide très poussé afin d'éviter toute interaction sur le parcours et minimiser la contamination qui provient des gaz résiduels du vide. Les molécules sont produites par chauffage et par évaporation sous vide (environ $10^{-10}$ Torr) dans une cellule communiquant avec l'enceinte d'épitaxie. Les matériaux utilisés en épitaxie peuvent être de nature différente et se présenter sous forme solide, liquide ou gazeuse. Ils sont les éléments constitutifs des alliages semi-conducteurs dit "composés" (Compound semiconductors) c'est-à-dire formés de 2 éléments chimiques simples au minimum. (Par exemple, du Gallium et de l'Azote pour GaN ou nitrure de gallium ; le gallium, l'azote et l'arsenic pour GaAsN. Ils peuvent être aussi des matériaux de dopages des semi-conducteurs composés par exemple le Silicium et le Béryllium pour le dopage n ou p de GaAs.

L'invention se rapporte à la réalisation de semi-conducteurs composés contenant de l'azote ou "nitrures" tels que GaN, GaAsN, GaAsSbN ou les semi-conducteurs composés contenant de l'oxygène tel que ZnO; les matériaux contenant de l'oxygène tels que les oxydes de Fer, les cuprates (supraconducteurs YBaCuO par exemple).

D'autres matériaux peuvent être aussi réalisés comme les hydrures de silicium contenant de l'hydrogène.

La croissance de nitrures se fait de façon efficace en utilisant un jet d'atomes (N), de molécules excitées ($N_2^*$) ou de radicaux NH, $NH_2$ ou collectivement un mélange de ces espèces. On appelle plus loin ces espèces : les espèces réactives.

De façon similaire, pour la croissance d'oxydes, on utilisera un jet d'atomes d'oxygène (O) et de molécules excitées ($O_2^*$) ou des radicaux plus complexes.

Ces espèces réactives sont produites à l'aide de sources à craquages.

Ces sources à craquages permettent de communiquer de l'énergie aux molécules afin de casser les liaisons entre les atomes ou groupes d'atomes formant les molécules du gaz initial. Cette énergie est soit thermique c'est-à-dire que l'on introduit le gaz dans un volume chauffé. Cette température est de l'ordre de 1500°C au maximum pour des raisons technologiques.

Lorsque les températures nécessaires à un craquage efficace sont plus élevées, on utilise une source à plasma où la température du plasma est beaucoup plus élevée (plusieurs milliers de degrés centigrades). Ces sources à plasma sont de plusieurs sortes : source à plasma continu (source plasma "DC") ; à plasma ECR (pour "Electron Cyclotron Resonnance") ou le plus souvent en épitaxie par jets moléculaires à plasma radio-fréquence ou RF dite source plasma RF. De façon générale, l'invention se rapporte à la croissance de couches minces sous vide nécessitant l'apport d'un ou plusieurs matériaux générés sous formes d'espèces atomiques ou d'espèces atomiques ou moléculaires excitées

Par le contrôle des cellules d'évaporation et des sources, on crée un jet de molécules en direction du substrat ; on peut ainsi réaliser couche par couche des structures complexes permettant de réaliser des diodes laser, les transistors à forte mobilité d'électron (HEMT) ou bipolaires. La vitesse de croissance est de l'ordre de 1 à plusieurs μm par heure.

Le dépôt sous vide des couches semi-conductrices ou supraconductrices nécessite que les flux des divers matériaux arrivant sur les substrats soit tels que la croissance de la couche mince soit uniforme, c'est-à-dire qu'elle présente des propriétés (épaisseur, composition,...) constantes sur toute la surface du substrat. La surface de ces substrats peut être de quelques $mm^2$ à plusieurs milliers de $cm^2$.

On mentionnera dans l'état de la technique le brevet américain US4424104 décrivant un équipement d'épitaxie comprenant une source d'évaporation fermée par une grille.

Le document WO-A-9 856 965 décrit un équipement d'épitaxie comprenant une source d'évaporation fermée par une grille et un couvercle perforé qui sont tournables l'un par rapport à l'autre.

Le but de la présente invention est de proposer un équipement selon la revendication 1 permettant d'ajuster les caractéristiques du jet en cours d'utilisation. A cet effet, l'invention concerne selon son acception la plus générale un équipement d'épitaxie comprenant une enceinte d'épitaxie sous vide contenant un support du substrat, et à au moins une cellule d'évaporation sous vide du matériau d'épitaxie fermée par un diaphragme présentant des lumières et communiquant avec l'enceinte d'épitaxie par une bride de liaison caractérisé en ce qu'il comprend en outre une plaque mobile dont la section correspond à la section du diaphragme, placée en regard dudit diaphragme perforé.

Cette plaque placée en regard du diaphragme provoque les rebonds des espèces réactives entre la surface extérieure du diaphragme, les parois de la plaque et les surfaces environnantes intérieures de l'enceinte d'épitaxie.

La position (orientation, distance) entre les parois de la plaque et la surface extérieure du diaphragme permet d'ajuster les caractéristiques du flux d'espèces réactives, en particulier la variation de la position relative de la plaque et la surface extérieure du diaphragme permet de faire varier très fortement la quantité d'espèces réactives qui arrivent sur le substrat.

Ladite plaque présente une section correspondant à la section dudit diaphragme.

Selon une première variante, la plaque est mobile selon une direction perpendiculaire audit diaphragme.

Avantageusement, la course de ladite plaque est de 10 millimètres.

Selon une deuxième variante, la plaque est mobile angulairement pour former un dièdre variable avec le plan dudit diaphragme.

De préférence, la plaque est formée dans une tôle d'acier métallique ou diélectrique (par exemple quartz, nitrure de bore).

Selon un mode de réalisation particulier, la plaque est actionnée par un organe de liaison traversant la paroi de l'enceinte d'épitaxie par une traversée étanche.

Selon une première solution de mise en oeuvre, le diaphragme présente des perforations.

Selon une deuxième solution de mise en oeuvre, le diaphragme présente une lumière annulaire.

La présente invention sera mieux comprise à la lecture de la description d'un exemple non limitatif de réalisation, faisant référence aux dessins annexés où :

- la figure 1 représente une vue en coupe longitudinale de la cellule d'évaporation en position ouverte ;
- la figure 2 représente une vue en coupe longitudinale de la source de plasma en position fermée ;
- la figure 3 représente une vue de face de ladite source de plasma ;
- la figure 4 représente une vue schématique du dispositif de commande.
- les figures 5 et 6 représentent les courbes de concentration d'Azote dans le dépôt en fonction de la position de la plaque
- la figure 7 est la courbe représentative de l'effet de la position de la plaque sur les dépôts réalisés sur le substrat.

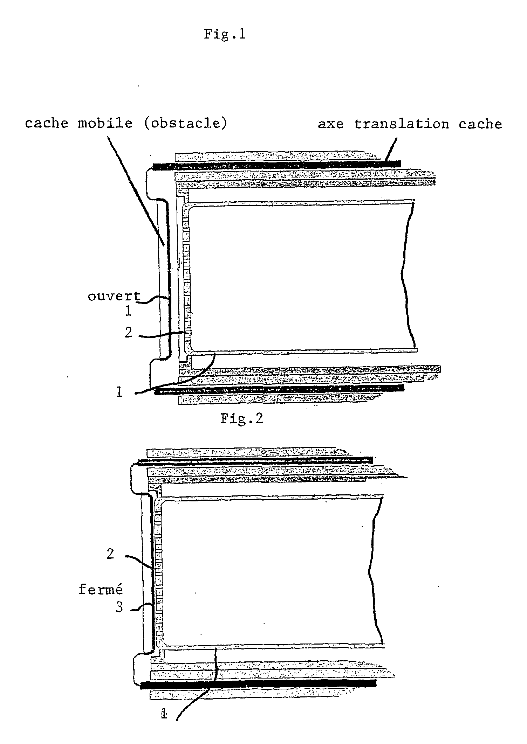

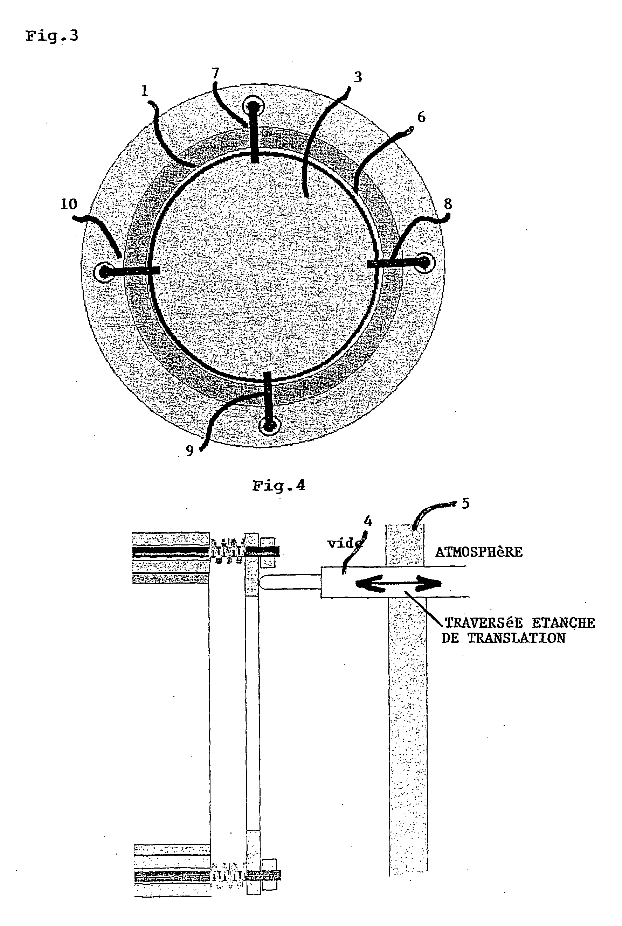

Les figures 1 et 2 représentent des vues schématiques de la cavité respectivement en position ouverte et fermée.

La cavité est délimitée par une enveloppe tubulaire (1) fermée à l'aval par un diaphragme perforé (2). La structure de cette cavité est traditionnelle est n'est pas décrite plus en détail.

Elle présente une plaque (3) de forme discale placée parallèlement au plan du diaphragme. Elle est réalisée en tôle métallique. Elle présente une section de 20 mm, correspondant sensiblement à la section de la source (1).

Cette plaque peut être déplacée entre une position de fermeture où elle est accolée au diaphragme, et une position d'ouverture où elle est écartée d'une distance maximale de l'ordre de 10 mm. Elle est actionnée par un mécanisme représenté en figure 4, comprenant une tige de commande (4) traversant la paroi de l'enceinte d'épitaxie (5).

La plaque est guidée par quatre tiges (7 à 10). Le jet moléculaire est formé au niveau d'une zone annulaire (6) entourant la plaque (3).

Les effets de l'invention sur la composition du nitrures GaAsN sont explicités par les résultats pratiques suivants.

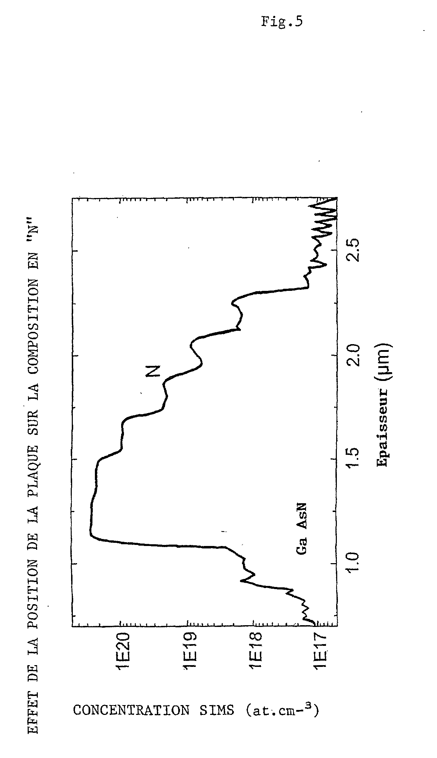

La courbe de la figure 5 montre la concentration d'azote mesurée par la technique familière dans le domaine de la spectrométrie d'ions secondaires (SIMS) dans une couche de matériau $GaAs_xN_{1-x}$, réalisée par épitaxie où x est la concentration de l'arsenic et 1-x celle de l'azote.

La couche a été réalisée en utilisant deux cellules d'effusion, une pour générer le jet de gallium, l'autre le jet d'arsenic.

Le jet d'azote est produit par une source plasma RF équipée de la présente invention. La plaque est positionnée à différentes distances du diaphragme durant la croissance de la couche, on observe sur la courbe une série de paliers qui correspondent chacun à chaque position de la plaque, la hauteur du palier donne la concentration d'azote mesurée par la technique SIMS en atomes par cm3, la longueur du palier en unité de μm indiqué en abscisse donne la durée pendant laquelle la plaque est laissée à la même position. On observe que la dynamique de réglage entre les positions extrêmes est très élevée puisqu'on mesure environ $2 \ 10^{+17}$ atomes par cm3 pour la position de la plaque la plus proche utilisée dans cette expérience et près de $2.8 \ 10^{+20}$ atomes par cm3 dans la position la plus ouverte utilisée dans cette expérience.

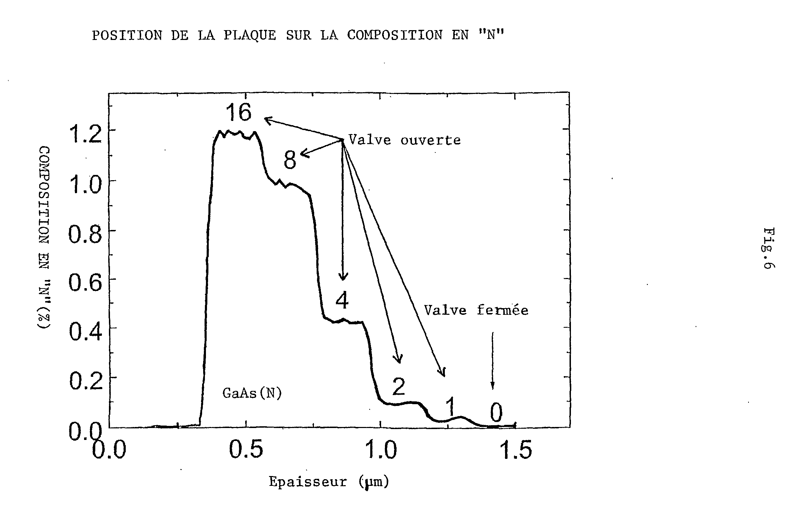

La figure 6 est une courbe similaire réalisée à l'aide de la même technique SIMS sur une couche similaire de $GaAs_xN_{1-x}$. mais où l'on a converti les concentrations en atomes par cm3 en % de l'élément simple dans l'alliage complet. Cette courbe montre que pour cette couche particulière on a pu faire varier là où on le souhaite la concentration de l'azote dans la couche entre une valeur sensiblement négligeable et une valeur égale à 1.2%. Ces valeurs sont des ordres de grandeurs des valeurs habituellement recherchées par les utilisateurs.

L'invention permet en outre de créer une diffusion des espèces réactives améliorant sensiblement l'homogénéité du dépôt au niveau du ou des substrats.

Afin de montrer cet effet on a réalisé l'expérience suivante :

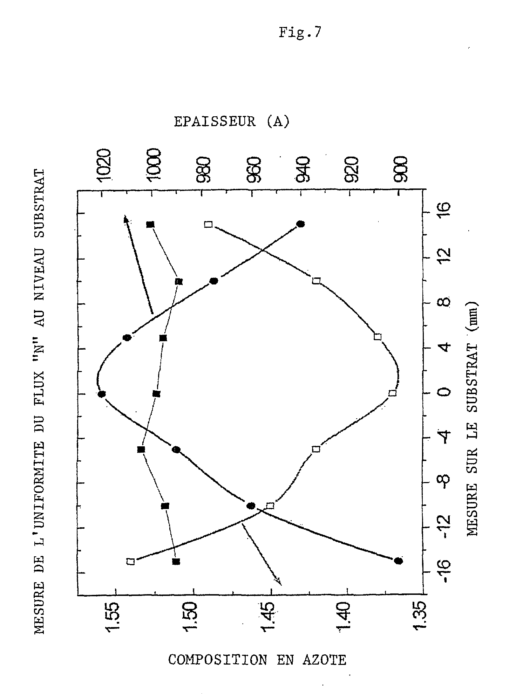

Les courbes de la figure 7 montrent la composition en azote en % (échelle de gauche) et l'épaisseur de la couche en angström (échelle de droite), l'abscisse est la distance où la mesure est faite par rapport au centre du substrat (wafer) en mm.

La mesure est faite par diffraction de rayon X une technique qui permet de mesurer l'épaisseur d'une couche mince et la concentration des divers éléments qui la compose sur plusieurs points de la surface du substrat.

On observe que l'allure de la variation d'épaisseur est sensiblement l'inverse de celle de l'épaisseur. On voit que la concentration d'azote est faible là où l'épaisseur est forte (centre de la couche position zéro) et forte là où l'épaisseur est plus faible.

Le flux incident des espèces azote réactives est le produit de la concentration par l'épaisseur, ce produit est fait et représenté par la courbe du haut (carrés). Cette courbe représente la valeur V du flux des espèces azote réactives arrivant sur la surface du substrat.

Le calcul à partir des valeurs V relevées sur la courbe montre une uniformité inférieure à 1.7%.

L'uniformité est ici définie comme (Vmax-Vmin) divisée par la valeur moyenne de V égale à

(Vmax + Vmin) divisée par deux.

## Revendications

1. Équipement d'épitaxie comprenant une enceinte d'épitaxie sous vide contenant un support du substrat, et au moins une cellule d'évaporation sous vide du matériau d'épitaxie fermée par un diaphragme présentant au moins une lumière et communiquant avec l'enceinte d'épitaxie par une bride de liaison, comprenant en outre une plaque placée en regard dudit diaphragme perforé **caractérisé en ce que** ladite plaque est mobile de sorte que la distance de la plaque à la surface extérieure du diaphragme est variable et présente une section correspondant à la section dudit diaphragme ; le jet moléculaire étant formé au niveau d'une zone entourant la plaque.

2. Équipement d'épitaxie selon la revendication 1, **caractérisé en ce que** ladite plaque présente une forme discale.

3. Équipement d'épitaxie selon la revendication 1, **caractérisé en ce que** ladite plaque est mobile selon une direction perpendiculaire audit diaphragme.

4. Équipement d'épitaxie selon la revendication 2, **caractérisé en ce que** la course de ladite plaque est de 10 millimètres.

5. Équipement d'épitaxie selon la revendication 1, **caractérisé en ce que** ladite plaque est mobile angulairement pour former un dièdre variable avec le plan dudit diaphragme.

6. Équipement d'épitaxie selon l'une quelconque des revendications précédentes, **caractérisé en ce que** la plaque est formée dans une tôle métallique ou diélectrique (par exemple quartz, nitrure de bore).

7. Équipement d'épitaxie selon l'une quelconque des revendications précédentes, **caractérisé en ce que** la plaque est actionnée par un organe de liaison traversant la paroi de l'enceinte d'épitaxie par un manchon étanche.

8. Équipement d'épitaxie selon l'une quelconque des revendications précédentes, **caractérisé en ce que** le diaphragme présente des perforations.

9. Équipement d'épitaxie selon l'une quelconque des revendications 1 à 6, **caractérisé en ce que** le diaphragme présente une lumière annulaire.

## Claims

1. Epitaxy equipment comprising a vacuum epitaxy chamber containing a substrate support, and at least one vacuum evaporation cell of the epitaxy material closed by a diaphragm with at least one opening and communicating with the epitaxy chamber through a connecting flange, also comprising a plate in contact with the said perforated diaphragm, **characterised in that** the said plate is mobile such that the distance from the plate to the outside surface of the diaphragm is variable and has a section corresponding to the section of the said diaphragm; the molecular jet being formed in an area surrounding the plate.

2. Epitaxy equipment according to claim 1, **characterised in that** the said plate is disk shaped.

3. Epitaxy equipment according to claim 1, **characterised in that** the said plate is mobile along a direction perpendicular to the said diaphragm.

4. Epitaxy equipment according to claim 2, **characterised in that** the travel distance of the said plate is 10 millimetres.

5. Epitaxy equipment according to claim 1, **characterised in that** the said plate is mobile in the angular direction to form a variable dihedron with the plane of the said diaphragm.

6. Epitaxy equipment according to any one of the previous claims, **characterised in that** the plate is formed from a metallic or dielectric plate (for example quartz or boron nitride).

7. Epitaxy equipment according to any one of the previous claims, **characterised in that** the plate is activated by a connecting device passing through the wall of the epitaxy chamber through a sealed sleeve.

8. Epitaxy equipment according to any one of the previous claims, **characterised in that** the diaphragm has perforations.

9. Epitaxy equipment according to any one of claims 1 to 6, **characterised in that** the diaphragm is provided with an annular opening.

**Patentansprüche**

1. Epitaxie-Ausrüstung, aufweisend einen Vakuum-Epitaxiebehälter, der einen Substratträger enthält, und mindestens eine Vakuum-Verdampferzelle des Expitaxie-Materials, die durch eine Membran geschlossen ist, die mindestens eine Öffnung aufweist und mit dem Epitaxiebehälter durch einen Verbindungsflansch kommuniziert, weiterhin aufweisend eine Platte, die gegenüber der besagten perforierten Membran gestellt ist, **dadurch gekennzeichnet, dass** die besagte Platte beweglich ist, so dass der Abstand der Platte zur Außenfläche der Membran variabel ist, und einen Durchmesser aufweist, der dem Durchmesser der besagten Membran entspricht, wobei der Molekularstrahl auf Ebene eines Bereichs ausgebildet wird, der die Platte umgibt.

2. Epitaxie-Ausrüstung nach Anspruch 1, **dadurch gekennzeichnet, dass** die besagte Platte diskal geformt ist.

3. Epitaxie-Ausrüstung nach Anspruch 1, **dadurch gekennzeichnet, dass** die besagte Platte senkrecht zur besagten Membran beweglich ist.

4. Epitaxie-Ausrüstung nach Anspruch 2, **dadurch gekennzeichnet, dass** die Weglänge der besagten Platte 10 Millimeter beträgt.

5. Expitaxie-Ausrüstung nach Anspruch 1, **dadurch gekennzeichnet, dass** die besagte Platte im Winkel beweglich ist, um mit der Ebene der besagten Membran einen variablen Dieder auszubilden.

6. Epitaxie-Ausrüstung nach einem der vorhergehenden Ansprüche, **dadurch gekennzeichnet, dass** die Platte aus einem metallischen oder dielektrischen Blech (zum Beispiel Quarz, Bornitrid) ausgebildet ist.

7. Epitaxie-Ausrüstung nach einem der vorhergehenden Ansprüche, **dadurch gekennzeichnet, dass** die Platte von einem Verbindungsorgan betätigt wird, das die Wand des Epitaxie-Behälters durch eine dichte Muffe hindurch durchquert.

8. Expitaxie-Ausrüstung nach einem der vorhergehenden Ansprüche, **dadurch gekennzeichnet, dass** die Membran perforiert ist.

9. Epitaxie-Ausrüstung nach einem der Ansprüche 1 bis 6, **dadurch gekennzeichnet, dass** die Membran eine ringförmige Öffnung aufweist.

Fig.1

cache mobile (obstacle)                    axe translation cache

ouvert
1
2

1

Fig.2

2

fermé
3

1

Fig.3

Fig.4

vide

ATMOSPHÈRE

TRAVERSéE ETANCHE
DE TRANSLATION

EFFET DE LA POSITION DE LA PLAQUE SUR LA COMPOSITION EN "N"

Fig.5

POSITION DE LA PLAQUE SUR LA COMPOSITION EN "N"

Fig. 6

EP 1 392 894 B1

MESURE DE L'UNIFORMITE DU FLUX "N" AU NIVEAU SUBSTRAT

Fig. 7

EP 1 392 894 B1